# FASCICULE DE BREVET EUROPEEN

(11) **EP 3 080 556 B1**
(45) Date de publication et mention de la délivrance du brevet: **17.10.2018**
(21) Numéro de dépôt: 14827496.2
(22) Date de dépôt: 11.12.2014
(51) Int. Cl.: G01D 11/24, B29C 33/12, B29C 39/10, G01L 19/06, G01L 19/14

(54) **DISPOSITIF COMPORTANT UN CAPTEUR PROTEGE PAR DE LA RESINE**
VORRICHTUNG MIT EINEM DURCH HARZ GESCHÜTZTEN SENSOR
DEVICE COMPRISING A RESIN PROTECTED SENSOR

(30) Priorité: 12.12.2013 FR 1362524
(43) Date de publication de la demande: 19.10.2016
(73) Titulaire: SC2N, 94046 Creteil Cedex (FR)
(72) Inventeur: GRONIER, Mathieu, F-14190 Saint-Germain-le-Vasson (FR); GUEGUEN, Olivier, F-14210 Baron sur Odon (FR); GRAVAT, Denis, F-94046 Creteil Cedex (FR)
(74) Mandataire: Garcia, Christine
(86) Numéro de dépôt international: PCT/FR2014/053274
(87) Numéro de publication internationale: WO 2015/087001

(56) Documents cités:
- JP-A- S57 147 027
- US-B1- 6 688 353
- US-B2- 7 749 797

## Description

L'invention concerne un dispositif comportant un boîtier dans lequel est disposé un capteur en partie noyé dans de la résine.

Dans les applications automobiles, certains composants électroniques doivent être protégés afin d'augmenter leur durée de vie. A cet effet, il est connu de les placer dans un boîtier, puis de remplir le boîtier avec une résine liquide qui, en durcissant, les protégera de l'environnement extérieur.

Lorsqu'un composant électronique comporte un capteur dont l'élément sensible doit être exposé à son environnement, la résine ne doit cependant pas recouvrir cet élément sensible.

Le document US 6 688 353 B1 décrit un dispositif comportant un composant électronique comportant un capteur de pression, un boîtier comportant des parois latérales attachées à un fond de manière à définir une cavité, et une résine remplissant la cavité de manière à immerger le composant électronique en laissant émerger une partie sensible du capteur. Le composant électronique repose sur des plots qui font saillie du fond du boîtier. Probablement sous l'effet des variations de température ou de pression, des fissures peuvent cependant apparaître dans la résine, risquant de mettre en contact le composant électronique avec l'environnement extérieur. Des soudures ou des pistes du composant électronique peuvent alors s'oxyder, ce qui réduit sa durée de vie.

Il existe un besoin pour un dispositif conférant une protection améliorée au composant électronique.

Un objectif de la présente invention est de répondre, au moins partiellement à ce besoin.

L'invention propose un dispositif comportant :
- un boîtier comportant une paroi latérale et un fond de manière à définir une cavité ;
- un composant électronique comportant un capteur pourvu d'un élément sensible ;
- une résine remplissant la cavité de manière à immerger le composant électronique en laissant émerger ledit élément sensible ;
le composant électronique reposant sur au moins un plot faisant saillie dudit fond de façon à empêcher la formation de bulle d'air dans la résine.

Selon l'invention, ledit au moins un plot est écarté de la paroi latérale d'une distance supérieure à 1 mm ou est en contact avec ladite paroi latérale.

Comme on le verra plus en détail dans la suite de la description, un tel agencement améliore la durée de vie du composant électronique. Sans être lié par une théorie, les inventeurs considèrent que l'agencement revendiqué limite la génération de bulles à proximité dudit au moins un plot, ces bulles étant considérées comme à l'origine de certaines fissures.

Un dispositif selon l'invention peut encore comporter une ou plusieurs des caractéristiques optionnelles suivantes :
- le capteur est un capteur de pression ;
- la résine s'étend sensiblement jusqu'au bord supérieur de la paroi latérale ;
- le composant électronique est un circuit imprimé, ou PCB, de l'anglais *« Printed circuit board »* ou carte électronique ;
- le boîtier comporte une voûte présentant un orifice de remplissage et un orifice d'évent ;
- la résine est choisie dans le groupe constitué par une résine époxy, silicone ou polyuréthane, mono- ou bi-composants.

Le dispositif selon l'invention peut être en particulier un boîtier par lequel circule de l'air d'admission pour un véhicule automobile, dit TMPA, en anglais *« Temperature and Measurement Air Pressure ».*

L'invention concerne également un véhicule équipé d'un dispositif selon l'invention.

D'autres caractéristiques et avantages de l'invention apparaîtront encore à la lecture de la description qui va suivre, et à l'examen du dessin annexé dans lequel :
- la figure 1 représente schématiquement, en coupe longitudinale médiane, un dispositif selon l'invention ;
- la figure 2 représente une coupe du dispositif de la figure 1 selon le plan P, et ;
- la figure 3 représente une variante du dispositif de la figure 1, observée suivant le plan P.

Dans les différentes figures, des références identiques sont utilisées pour désigner des organes identiques ou analogues.

Sauf indication contraire, par « comportant un » ou « comprenant un », on entend « comportant au moins un ».

Sauf indication contraire, une « résine » est à l'état solide.

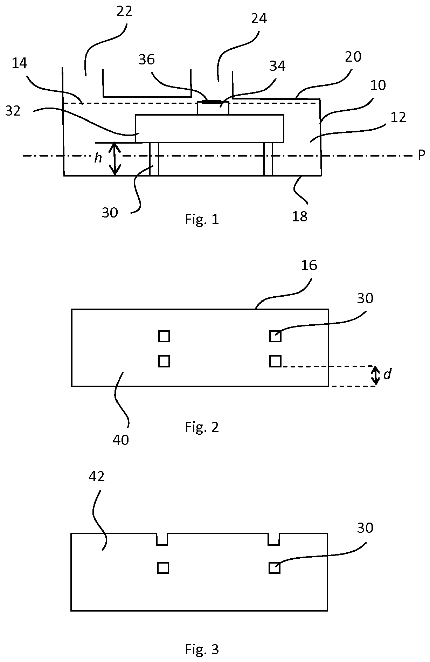

La figure 1 représente un exemple de dispositif selon l'invention. Ce dispositif comporte un boîtier 10 définissant une cavité 12 sensiblement fermée, remplie de résine 14. Le trait en pointillés indique le niveau supérieur de la résine 14. Le boîtier 10 comporte une paroi latérale 16, un fond 18 et une voûte 20.

La paroi latérale 16 et/ou le fond 18, voire le boîtier 10, sont de préférence en un matériau plastique, de préférence choisi parmi les thermoplastiques.

La voûte est percée d'un orifice de remplissage 22 et d'un orifice d'évent 24. Des plots 30 font saillie du fond 18.

Un composant électronique 32 comportant un capteur 34 est posé sur les plots 30. Le composant électronique 32 est immergé dans la résine 14, à l'exception d'un élément sensible 36 du capteur 34 qui émerge de la résine 14 de manière à être exposé à l'environnement. Le composant électronique est bien connu de l'homme du métier.

La résine est de préférence choisie parmi les résines époxy, silicone ou polyuréthane, mono- ou bi-composants. De préférence, la résine s'étend sensiblement jusqu'à la voûte.

Comme représenté sur la figure 2, les plots 30 sont écartés de la paroi latérale 16 d'une distance d supérieure à 1 mm, la distance d correspondant à l'écartement minimal entre le plot 30 considéré et n'importe quel point de la paroi latérale 16.

Dans le mode de réalisation de la figure 3, certains plots 30 sont en contact avec la paroi latérale.

Pour fabriquer un dispositif comme celui représenté sur les figures, on dispose le composant électronique 32 sur les plots 30, puis on verse de la résine à l'état liquide dans la cavité 12, par l'intermédiaire de l'orifice de remplissage 22.

De préférence, avant d'être coulée dans le boîtier 10, la résine à l'état liquide est dégazée, c'est-à-dire placée dans un environnement dont la pression est réduite, par exemple à une pression inférieure à 20 mbar, par exemple de 10 mbar, afin d'extraire les gaz, et en particulier l'air, éventuellement présents.

La viscosité de la résine à l'état liquide est typiquement supérieure à 0.2 Pa.s et/ou inférieure à 0.5.

Au fur et à mesure que la cavité 12 se remplit, l'air qui y était contenu s'échappe par l'orifice d'évent 24.

Le remplissage est stoppé avant que la résine ne recouvre l'élément sensible 36. De préférence, la résine noie le composant électronique 32, à l'exception du seul élément sensible 36, qui reste exposé à l'environnement.

Les inventeurs ont constaté que l'écartement des plots 30 de la paroi latérale 16 libère un passage 40 pour la résine qui est suffisant pour éviter l'emprisonnement de bulles.

Dans la variante de la figure 3, lorsqu'un plot est en contact avec la paroi latérale 16, aucune bulle ne peut apparaître entre le plot et la paroi latérale. Dans un mode de réalisation préféré, le plot 30 est venu de matière avec la paroi latérale 16.

La résine à l'état liquide est alors durcie.

Les inventeurs ont constaté que l'absence de bulles à proximité des plots limite le risque de création de fissures susceptibles de mettre en contact le composant électronique avec l'environnement extérieur.

La résine peut ainsi assurer une protection du composant électronique 32 pendant une durée supérieure à celle des dispositifs selon la technique antérieure, en dépit des variations de température et de pression rencontrées dans une application à un véhicule automobile.

Bien entendu, l'invention n'est pas limitée au mode de réalisation décrit et représenté, fourni à titre d'exemple illustratif.

Par exemple, un plot 30 pourrait être disposé dans un coin 42 du boîtier 10.

## Revendications

1. Dispositif comportant :
- un composant électronique (32) comportant un capteur (34) pourvu d'un élément sensible (36) ;
- un boîtier (10) comportant une paroi latérale (16) et un fond (18) de manière à définir une cavité (12) ;
- une résine (14) remplissant la cavité de manière à immerger le composant électronique en laissant émerger ledit élément sensible,
le composant électronique reposant sur au moins un plot (30) faisant saillie dudit fond de façon à empêcher la formation de bulle d'air dans la résine, le plot étant écarté de la paroi latérale (16) d'une distance d supérieure à 1 mm ou en contact avec la paroi latérale (16).

2. Dispositif selon la revendication précédente, le capteur étant un capteur de pression.

3. Dispositif selon l'une quelconque des revendications précédentes, la résine s'étendant sensiblement jusqu'au bord supérieur de la paroi latérale.

4. Dispositif selon l'une quelconque des revendications précédentes, le composant électronique étant un circuit imprimé.

5. Dispositif selon l'une quelconque des revendications précédentes, le boîtier comportant une voûte présentant un orifice de remplissage (22) et un orifice d'évent (24).

6. Dispositif selon l'une quelconque des revendications précédentes, la résine étant choisie dans le groupe constitué par les résines époxy, silicone ou polyuréthane, mono- ou bi-composants.

7. Dispositif selon l'une quelconque des revendications précédentes, sous la forme d'un boîtier par lequel circule de l'air d'admission pour un véhicule automobile.

8. Véhicule équipé d'un dispositif selon l'une quelconque des revendications précédentes.

## Patentansprüche

1. Vorrichtung, umfassend:
- eine elektronische Komponente (32), umfassend einen Sensor (34), der mit einem sensiblen Element (36) versehen ist;
- ein Gehäuse (10), umfassend eine Seitenwand (16) und einen Boden (18), um einen Hohlraum (12) zu bilden;
- ein Harz (14), das den Hohlraum füllt, um die elektronische Komponente einzutauchen, wobei das sensible Element herausragend bleibt,
wobei die elektronische Komponente auf mindestens einem Bolzen (30) liegt, der aus dem Boden herausragt, um die Bildung einer Luftblase in dem Harz zu vermeiden, wobei der Bolzen von der Seitenwand (16) um einen Abstand d größer als 1 mm entfernt oder mit der Seitenwand (16) in Kontakt ist.

2. Vorrichtung nach dem vorhergehenden Anspruch, wobei der Sensor ein Drucksensor ist.

3. Vorrichtung nach einem der vorhergehenden Ansprüche, wobei sich das Harz im Wesentlichen bis zum oberen Rand der Seitenwand erstreckt.

4. Vorrichtung nach einem der vorhergehenden Ansprüche, wobei die elektronische Komponente eine gedruckte Schaltung ist.

5. Vorrichtung nach einem der vorhergehenden Ansprüche, wobei das Gehäuse eine Wölbung umfasst, die eine Füllöffnung (22) und eine Entlüftungsöffnung (24) aufweist.

6. Vorrichtung nach einem der vorhergehenden Ansprüche, wobei das Harz in der Gruppe ausgewählt ist, die von den Ein- oder Zweikomponenten- Epoxy-, Silikon- oder Polyurethan-Harzen gebildet ist.

7. Vorrichtung nach einem der vorhergehenden Ansprüche in Form eines Gehäuses, durch das die Ansaugluft für ein Kraftfahrzeug zirkuliert.

8. Fahrzeug, das mit einer Vorrichtung nach einem der vorhergehenden Ansprüche ausgestattet ist.

## Claims

1. Device comprising:
- an electronic component (32) comprising a sensor (34) provided with a sensitive element (36) ;
- a housing (10) comprising a side wall (16) and a bottom (18) so as to define a cavity (12);
- a resin (14) filling the cavity so as to submerge the electronic component, leaving said sensitive element protruding,
the electronic component resting on at least one protuberance (30) projecting from said bottom so as to prevent the forming of air bubbles in the resin, the protuberance being spaced apart from the side wall (16) by a distance d greater than 1 mm or being in contact with the side wall (16).

2. Device according to the preceding claim, wherein the sensor is a pressure sensor.

3. Device according to either one of the preceding claims, wherein the resin extends substantially up to the upper edge of the side wall.

4. Device according to any one of the preceding claims, wherein the electronic component is a circuit board.

5. Device according to any one of the preceding claims, wherein the housing has a top having a filling port (22) and a vent port (24).

6. Device according to any one of the preceding claims, wherein the resin is chosen from the group consisting of one-component or two-component epoxy, silicone or polyurethane resins.

7. Device according to any one of the preceding claims, which is in the form of a housing through which intake air for a motor vehicle flows.

8. Vehicle equipped with a device according to any one of the preceding claims.
